**Europäisches Patentamt**

**European Patent Office**

**Office européen des brevets**

(19)

(11) Publication number: **0 180 469**
**B1**

(12) # EUROPEAN PATENT SPECIFICATION

(45) Date of publication of patent specification: **21.06.89**

(51) Int. Cl.⁴: **H 04 N 7/137, H 03 M 7/46**

(21) Application number: **85307873.1**

(22) Date of filing: **30.10.85**

(54) Code converting system and method for band compression of digital signals.

(30) Priority: **30.10.84 JP 228631/84**

(43) Date of publication of application:
**07.05.86 Bulletin 86/19**

(45) Publication of the grant of the patent:
**21.06.89 Bulletin 89/25**

(84) Designated Contracting States:
**DE FR GB IT**

(56) References cited:
**US-A-4 077 053**
**US-A-4 179 710**
**US-A-4 217 609**

(73) Proprietor: **NEC CORPORATION**
**33-1, Shiba 5-chome, Minato-ku**
**Tokyo 108 (JP)**

(72) Inventor: **Furukawa, Akihiro**
**c/o NEC Corporation 33-1, Shiba 5-chome**
**Minato-ku Tokyo (JP)**

(74) Representative: **Pears, David Ashley et al**
**REDDIE & GROSE 16 Theobalds Road**
**London WC1X 8PL (GB)**

Courier Press, Leamington Spa, England.

## Description

### Background of the invention

The present invention relates to a code converting system for converting a digital signal consisting of a given number of bits into one consisting of a different number of bits, and more particularly to a code converting system suited to encoders for band compression of television signals or the like.

One of the known systems for efficiently encoding multi-level signals including television signals is the predictive encoding system disclosed in the Patent US—A—4,133,006 (Reference 1). This encoding system is provided with a code converting system for further efficient encoding of prediction error signals. Such a code converting system by the prior art comprises, as described in Patent US—A—4,534,055 (Reference 2), a run-length encoder for run-length encoding of the highest occurrence frequency level (level 0 for instance) of prediction error signals and a variable length encoder for variable length encoding of all other levels. The converter of the prior art, however, has the disadvantage that, when the highest occurrence frequency level consecutively emerges, the quantity of information generated becomes too small, resulting in underflow of the buffer memory used in the predictive encoser. To avoid the underflow, by the prior art, compression encoding, such as predictive encoding, is suspended when the occupancy of the buffer memory falls below a certain level, and input signals are transmitted intact as pulse code modulated (PCM) signals. This method, again, has the following three disadvantages:

(a) Based on the great difference in quantity of information generated depending on whether or not compression is achieved, the occupancy of the buffer memory will sharply increase. As a result, a rough encoding mode is selected to avoid overflow of the buffer memory, and invites a deterioration of the picture quality of decoded signals.

(b) The hardware structure is complicated by the control which alters the encoding method.

(c) The alteration of the encoding method can not be finely controlled.

A code converting system in accordance with the introductory part of claim 1 is known from US—A—4 217 609, wherein the first and second code forms are run length coding and difference quantizing coding respectively. However this known system is unable to maintain optimum control over the occupancy of the buffer memory.

An object of the present invention is to provide a code converting system cleared of the disadvantages stated above and capable not only of preventing underflow but also of effecting fine control of the occupancy of the buffer memory.

A converter according to the invention is characterised in the manner set forth in claim 1.

### Brief description of the drawings

Fig. 1 is a block diagram illustrating one preferred embodiment of the invention;

Figs. 2A and 2B are tables showing examples of variable length codes and run length codes for use in the embodiment illustrated in Fig. 1;

Fig. 3 is a circuit diagram illustrating an example of a controller used in Fig. 1; and

Figs. 4A and 4B are diagrams for describing the operation of the converter according to the invention.

### Description of the preferred embodiment

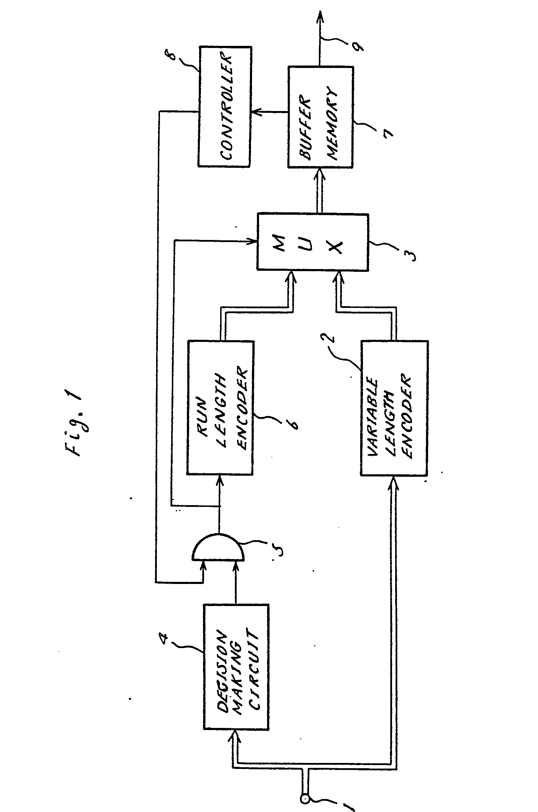

Referring to Fig. 1 an input terminal 1 receives a prediction error signal $e$ resulting from predictive encoding of a television signal. The prediction error signal corresponds, for instance, to the output of the quantizer 13 shown in Fig. 1 of Reference 1. A variable length encoder 2 converts the prediction error signal $e$ into a variable length code, and supplies it to a multiplexer 3 consisting of a selector.

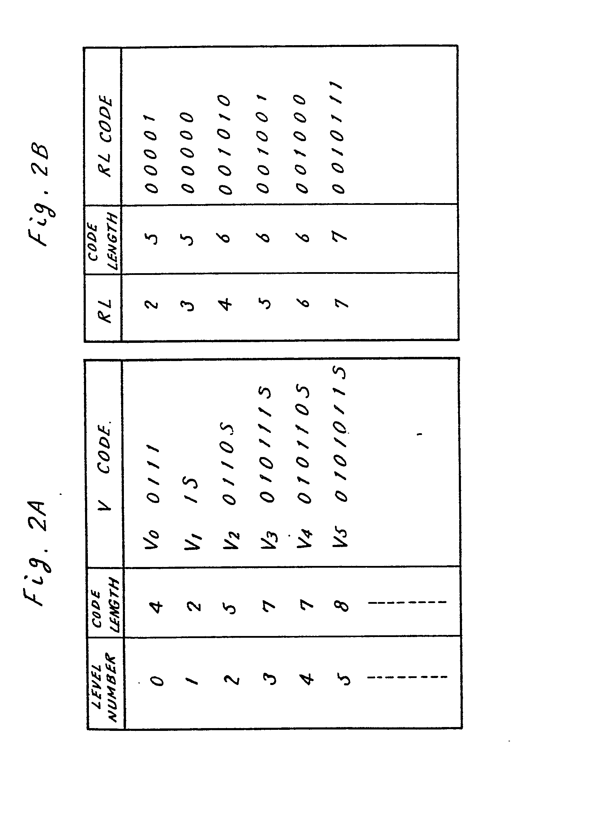

Fig. 2A shows examples of variable length codes. In Fig. 2A, level numbers 0, 1, 2, ... correspond, for instance, to levels 0, 1, 2, ..., and the V code collectively refers to variable length codes V0, V1, V2, ... S in a V code is a polarity bit showing whether the code is positive or negative. Referring again to Fig. 1, a decision making circuit 4 decides whether or not a given prediction error signal is zero, and supplies the decision to a gate circuit 5. Herein, when it is zero, "1" is supplied. The gate circuit 5, in response to an underflow signal supplied from a controller 8 to be described below, feeds the output of the decision making circuit 4 to a run-length encoder 6. The gate circuit 5 also supplies its output as a control signal to the multiplexer 3. The run-length encoder 6 run-length encodes the output of the decision making circuit 4 according to the table shown in Fig. 2B, and supplies its encoded output to the multiplexer 3. In Fig. 2B, RL represents the run length showing how many bits of the input signal to the run-length encoder 6 stay at a level "1". The multiplexer 3, in response to the control signal from the gate circuit 5, supplies the output of either the run-length encoder 6 or the variable length encoder 2 to a buffer memory 7. Hereupon, the encoder 6 is selected in response to "1", and the encoder 2 is in response to "0". The buffer memory 7, after temporarily storing the encoded outputs of the encoder 6 and 2, outputs them to a transmission line 9 at a constant speed. The buffer memory 7 counts the occupancy from the difference between the write address and the read address, and feeds it to the controller 8. For details on such a buffer memory, reference may be made to Figs. 1 and 2 of the Patent US—A—4,215,369. The controller 8, when the buffer occupancy is smaller than a first value T1, supplies an underflow indication signal (0") showing underflow of the buffer memory 7 to the gate circuit 5. This underflow signal continues to be supplied until the occupancy reaches a second value T2 (T1<T2). Incidentally, the variable length encoder 2 consists of a read only memory (ROM) for storing the table of Fig. 2A, and the decision making circuit 4, of a comparator circuit.

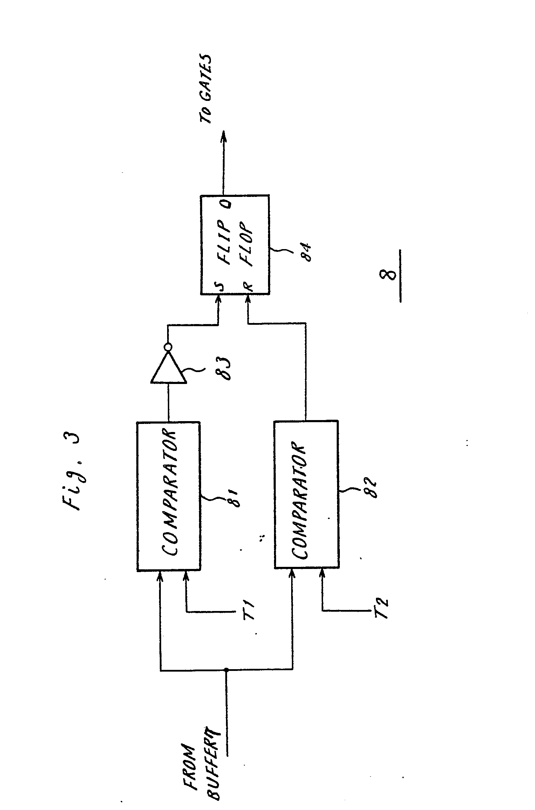

Referring now to Fig. 3, the controller 8 comprises a comparator 81 for comparing the first value T1 and the occupancy, an inverter 83 for inverting the output of the comparator 81, another comparator 82 for comparing the occupancy and the second value T2, and a flipflop 84 responding to the outputs of these two comparators 81 and 82. In this structure, when the occupancy is smaller than T1, the flipflop 84 is set, and produces "1" in its Q-terminal. In this state, when the occupancy increases between T1 and T2, the flipflop 84 continues to produce "1". When the occupancy further increases beyond T2, the comparator 82 resets the flipflop 84, which then produces "0".

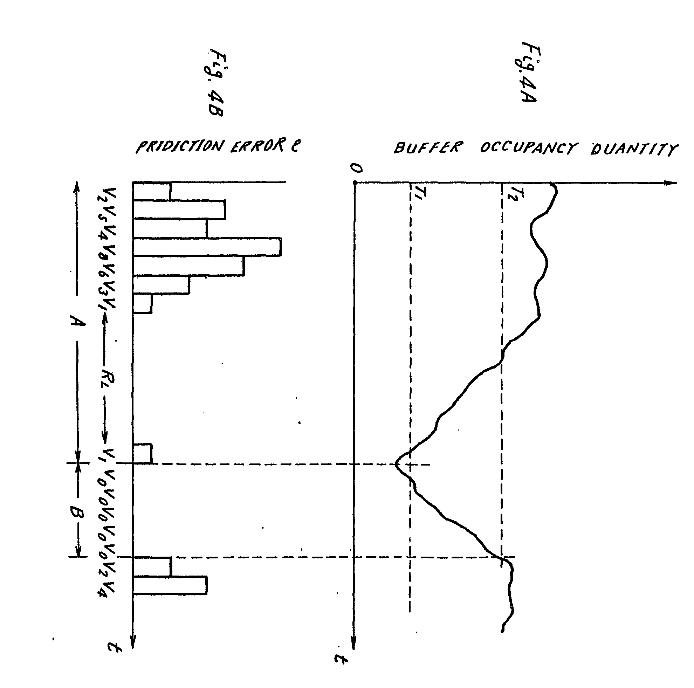

Figs. 4A and 4B are diagrams for describing the control of the buffer occupancy. In these figures, V2, V5, V4 and RL represent variable length codes and the run-length code in Figs. 2A and 2B, respectively. In normal operation, since the controller 8 produces the underflow indication signal "1" showing that the buffer memory 7 is not underflow, the signal "1" takes control of the gate 5 which is enabled to respond to the output of the decision making circuit 4. Therefore, the gate 5 supplies the output from the decision making circuit 4 to the multiplexer 3 which selects nonzero variable codes V2, V5, V4, ... or the run length code depending upon whether the prediction error signal is zero or not, as in section A of Fig. 4B.

However, when underflow of the buffer memory 7 is detected, the controller 8 supplies the underflow indication signal "0" to the gate 5. It flows that the gate 5 is disabled to provide the control signal "0" to the multiplexer 3 which selects the output of the variable length encoder 2 such as variable length codes V1, V0, V0, ... as shown in section B, irrespective of the detection of the level zero signal in the decision making circuit 4. As long as only variable length codes are selected, even if the level zero signal consecutively appears, the occupancy of the buffer memory 7 will increase, as shown in Fig. 4A. After that, when the buffer occupancy reaches the prescribed level T2, either a run-length code or a variable length code is selected again as in section A.

As hitherto described, the present invention makes it possible to realize a system free of picture quality deterioration, as it enables encoded information stored in the buffer memory to be gradually increased by variable length-encoding all the input signals in response to an underflow indication signal from the controller. The invention further makes it possible to set the length of section B as desired by adequately determining the two thresholds T1 and T2 and thereby to control the buffer memory occupancy more finely.

## Claims

1. A code converting system comprising first and second converting means (2, 6) for converting an input code resulting from the encoding of multi-level signals in two prescribed manners into a first code form and a second code form respectively, selector means (3) for selecting either the first code form or the second code form in response to a selection signal, a memory (7) for storing the output of the selector means and supplying it to a transmission line (9) at a constant speed and generating a signal indicating the memory occupancy, and control means (8) providing the selection signal to control the selector means (3) to output the first code form when the memory occupancy is below a prescribed level, characterized in that the first and second code forms are variable length codes and run length codes respectively and in that the control means (8) compare a memory occupancy signal with lower and higher thresholds (T1, T2) and control the selector means (3) to output solely the variable length codes when the memory occupancy signal falls below the lower threshold (T1) and thereafter until the memory occupancy signal rises above the higher threshold (T2).

2. A code converting system as claimed in claim 1, characterized by a detector (4) for determining whether or not the input code is zero, and an AND gate circuit (5) for ANDing a signal from the control means (8) with the output of the detector (5) to provide the selection signal.

## Patentansprüche

1. Codewandelsystem mit einer ersten und einer zweiten Wandeleinrichtung (2, 6) zum Wandeln eines Eingangscodes, der durch die Codierung eines Vielfachpegel-Signals auf zwei beschriebene Arten entstanden ist, in eine erste Codeform bzw. eine zweite Codeform, eines Auswahleinrichtung (3) zum Auwählen der ersten Codeform oder der zweiten Codeform abhängig von einem Auswahlsignal, einem Speicher (7) zum Speichern der Ausgabe der Auswahleinrichtung und zum Liefern der Ausgabe an eine Übertragungsleitung (9) mit einer konstanten Geschwindigkeit und Erzeugen eines Signals, das die Speicherbelegung angibt, und mit einer Steuereinrichtung (8), die das Auswahlsignal liefert zum Steuern der Auswahleinrichtung (3), wodurch die erste Codeform ausgegeben wird, wenn die Speicherbelegung unterhalb eines bestimmten Werts liegt, dadurch gekennzeichnet, daß die erste und die zweite Codeform ein Variable-Längen-Code bzw. ein Run-Längen-Code ist und daß die Steuereinrichtung (8) ein Speicherbelegungssignal mit einem niedrigen und einem hohen Schwellwert (T1, T2) vergleicht und die Auswahleinrichtung (3) so steuert, daß ausschließlich die Variabel-Längen-Codes ausgegeben werden, wenn das Speicherbelegungssignal unter den niedrigen Schwellenwert (T1) fällt sowie danach, bis das Speicherbelegungssignal über den oberen Schwellwert (T2) ansteigt.

2. Codewandelsystem nach Anspruch 1, gekennzeichnet durch einen Detektor (4) zum Bestimmen, ob der Eingangscode Null ist, und eine UND-Gatterschaltung (5) zur UND-Verknüpfung eines Signals von der Steuereinrichtung (8) mit der Ausgabe des Detektors (5) zum Bereitstellen des Auswahlsignals.

**Revendications**

1. Système de conversion de code comprenant des premier et second moyens de conversion (2, 6) pour convertir un code d'entrée résultant du codage de signaux multi-niveaux en deux manières prescrites pour donner une première forme de code et une seconde forme de code, respectivement, un moyen de sélecteur (3) pour sélectionner soit la première forme de code soit la seconde forme de code en réponse à un signal de sélection, une mémoire (7) pour stocker la sortie du moyen de sélecteur et la fournir à une ligne de transmission (9) à une vitesse constante et générer un signal indiquant l'occupation de la mémoire, et un moyen de commande (8) fournissant le signal de sélection de manière à commander le moyen de sélecteur (3) pour sortir la première forme de code lorsque l'occupation de la mémoire est inférieure à un niveau prescrit, caractérisé en ce que les première et seconde formes de codes sont des codes de longueur et des codes de longueur d'exécution variables respectivement, et en ce que le moyen de commande (8) compare un signal d'occupation de mémoire avec des seuils inférieur et supérieur (T1, T2) et commande le moyen de sélecteur (3) pour sortir seulement les codes de longueur variable lorsque le signal d'occupation de mémoire tombe au-dessous de seuil inférieur (T1) et ensuite tant que le signal d'occupation de mémoire ne s'est pas élevé au-dessus du seuil supérieur (T2).

2. Système de conversion de code selon la revendication 1, caractérisé par un détecteur (4) pour déterminer si oui ou non le code d'entrée est zéro, et un circuit (5) à porte ET pour faire subir une opération ET à un signal provenant du moyen de commande (8) avec la sortie du détecteur (5) afin de fournir le signal de sélection.

Fig. 1

EP 0 180 469 B1

## Fig. 2A

| LEVEL NUMBER | CODE LENGTH | V CODE | |
|---|---|---|---|
| 0 | 4 | V0 | 0111 |
| 1 | 2 | V1 | 1S |
| 2 | 5 | V2 | 0110S |
| 3 | 7 | V3 | 010111S |
| 4 | 7 | V4 | 010110S |
| 5 | 8 | V5 | 0101011S |

## Fig. 2B

| RL | CODE LENGTH | RL CODE |
|---|---|---|
| 2 | 5 | 00001 |
| 3 | 5 | 00000 |
| 4 | 6 | 001010 |
| 5 | 6 | 001001 |
| 6 | 6 | 001000 |
| 7 | 7 | 0010111 |

Fig. 3

FROM
BUFFER

COMPARATOR
81

T1

COMPARATOR
82

T2

83

S FLIP  Q
  FLOP
R
84

TO GATES

8

Fig.4A

Fig. 4B